# EUROPEAN PATENT APPLICATION

(11) **EP 0 665 661 A2**
(43) Date of publication of application: **02.08.1995**
(21) Application number: 95100914.1
(22) Date of filing: 24.01.1995
(51) Int. Cl.: H04B 14/04

(54) **Digital signal processing apparatus and method and dither signal generating apparatus**

(30) Priority: 28.01.1994 JP 24895/94
(71) Applicant: SONY CORPORATION, Tokyo (JP)
(72) Inventor: Yasuda, Nobuyuki, c/o Sony Corporation, Tokyo (JP)
(74) Representative: Melzer, Wolfgang, Dipl.-Ing.

(57) **Abstract**

A digital signal processing apparatus and a method for carrying out a re-quantization process for turning an inputted digital signal into a digital signal with a smaller bit number includes a signal generator (10) and a re-quantization processor (13). The signal generator has a data generator (1), a delay circuit (2) and an adder (4) and generates a dither signal for which an amount of a high frequency component is larger than that of the low frequency component. The data generator (1) generates M-series data-like non-correlating data. The delay circuit (2) delays the output from the data generator (1). The adder adds (4) the output from the delay circuit and an output from the delay circuit for which the polarity has been inverted (3). In the re-quantization process, the dither signal from the signal generator and the inputted signal are added (12) and the added signal is then re-quantized (13).

## Description

### BACKGROUND

### 1. Field Of The Invention

The present invention relates to a digital signal processing apparatus and method and a dither signal generating apparatus. More particularly, the present invention relates to a digital signal processing apparatus and method which employs a dither signal, and a dither signal generating apparatus.

### 2. Background of the Invention

When N-bit data generated by digital signal processing occurring in circuits such as digital filters and DSP (Digital Signal Processing) circuits are supplied to another signal processing sections, sometimes fraction processing such as rounding-down or rounding off has to be carried out on the lower bit data of the N-bit data so as to re-quantize the data into M bit (N>M) data to ensure that the data match with the operation bit number (M bits) for the downstream signal processing sections.

It is known that the data signal is added with a low level dither signal, the linearity of the LSB (Least Significant Bit) level is increased and the tonal quality is improved upon.

In this case, the randomness of the noise level of the dither signal is greater if the noise signal taken as the dither signal is larger. Also, a large energy level is preferable for raising the linearity. It is, however, desirable for the noise level to have a distribution which at least falls within the level of one bit step for the data quantization.

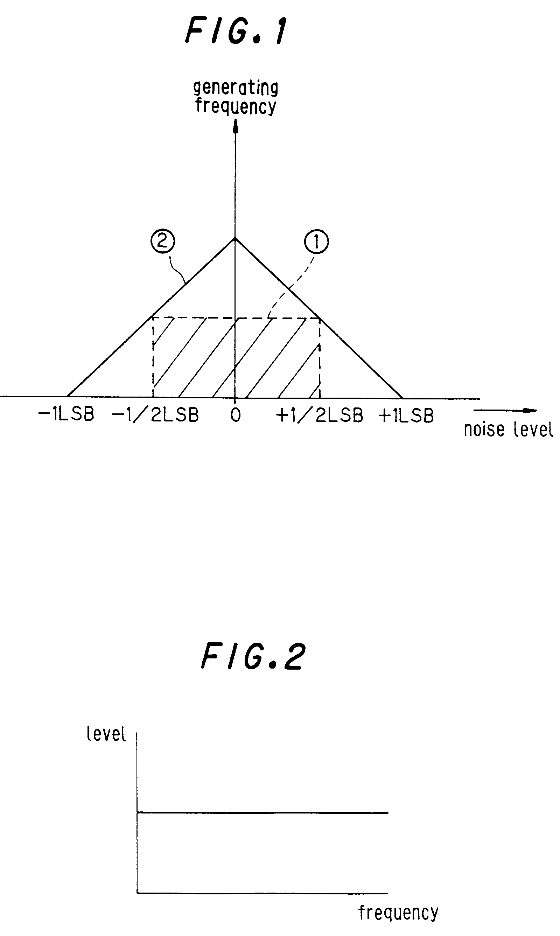

If the dither signal noise is generated at approximately the same generating frequency with respect to the noise level as shown by the relationship between the noise level of the dither signal and the generating frequency indicated by the dashed line (1) shown in FIG. 1, the energy (the area for the inclined line) which is the dither signal cannot be made to be so large because the noise component for which the absolute value of the level is large is generated in the same way. As a result, there are therefore cases where dither signals for raising the linearity do not possess sufficient energy. Therefore, a dither signal is adopted so that the maximum generating frequency exists where the distribution of the noise level is zero as shown by the solid line (2) in Fig. 1, with the generating frequency then reducing as the absolute value for the level reduces (this kind of dither signal will hereinafter be referred to as a distribution dither signal). In this way, it is possible to both increase the energy and increase the linearity of the dither signal.

A dither signal which has the kind of uniform characteristic shown in FIG. 2 can therefore be used so as to take into account the point of view of having a frequency characteristic of a dither signal which can be added to digital data during re-quantization. However, this means that the noise level of noise other than re-quantization noise is also perceptibly increased. In particular, when a dither signal of the necessary level is added in order to increase linearity this is accompanied by problems which go with the increasing of the noise level by 3 to 6 dB. Namely, the increasing of the linearity is detrimental to the S/N ratio with this therefore causing a perceptible increase in the noise.

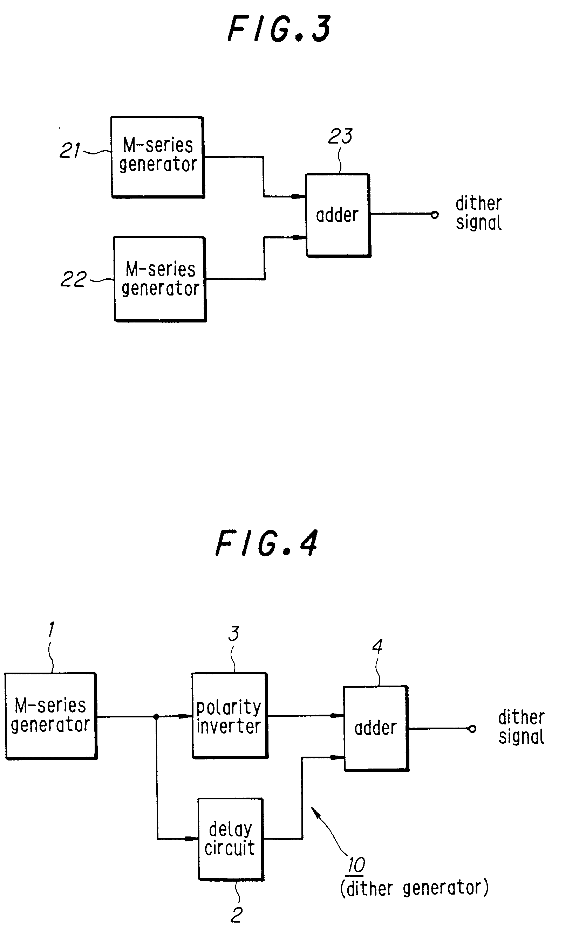

Also, the kind of distribution dither signal shown by (2) in FIG. 1 is generated by using a plurality of M-series generators 21 and 22 of the kind shown in FIG. 3, the output of which is then added at an adder 23. Each of the M-series generators 21 and 22 therefore reciprocally output the non-correlating random data irrespective of each other. The noise data obtained by adding therefore peaks at zero level noise so as to give a level characteristic where the generation frequency falls as the absolute value for the level becomes large. Namely, the characteristic shown by (2) in FIG. 1 is obtained.

A circuit of a comparatively large scale with a plurality of generators is therefore required in order to obtain this kind of dither signal, which presents economic problems with regards to this apparatus.

### SUMMARY OF THE INVENTION

It is therefore an object of the present invention to provide a digital signal processing apparatus which resolves the aforementioned problems.

It is another object of the present invention to provide a dither signal generating apparatus which resolves the aforementioned problems.

It is also a further object of the present invention to provide a digital signal processing method which resolves the aforementioned problems.

According to the present invention, there is provided a digital signal processing apparatus which includes a signal generator, an adder, and a re-quantizer. The signal generator is for generating a dither signal having a larger amount of a high frequency component than that of a low frequency component. The adder is for adding a dither signal from the signal generator and an inputted signal. The re-quantizer is for carrying out re-quantization processing on an output signal from the adder.

According to another aspect of the present invention, there is provided a dither signal generator for generating a dither signal having a larger amount of a high frequency component than that of a low frequency component which includes a data generator and a signal generator. The data generator is for generating non-correlating data. The signal generator is for generating a dither signal having a larger amount of a high frequency component than that of a low frequency component by subtracting a delayed output for the non-correlating data outputted from the data generator and the output from the data generator.

According to a still another aspect of the present invention, there is provided a digital signal processing method for carrying out a re-quantization process for turning an inputted digital signal into a digital signal with a smaller bit number. In this method, a dither signal having a larger amount of a high frequency component than that of a low frequency component is generated by subtracting delayed non-correlating data outputted from a data generator and non-correlating data outputted from the data generator. A generated dither signal and an inputted dither signal are then added and the added signal is then re-quantized.

Therefore, according to the present invention, a signal having a frequency characteristic in which the amount of the high frequency component is larger than that of the low frequency component is used as the dither signal to be added to the inputted digital signal. The energy distribution for the dither energy level can therefore be made large at a band which is higher than the audible frequency band so that this can be made to be at least the dither component within the audible frequency band. This means that the influence of the dither noise on a perceptible level can be reduced, the level of the dither signal can be raised and the re-quantization linearity can therefore be raised.

### BRIEF DESCRIPTION OF THE DRAWINGS

FIG. 1 is a graph illustrating the distribution of the dither signal;
FIG. 2 is a graph illustrating a usual dither signal characteristic;
FIG. 3 is a block diagram of a usual distribution dither signal generator;
FIG. 4 is a block diagram of an embodiment of a dither signal generating apparatus according to the present invention;
FIG. 5 is a block diagram of a digital signal processing apparatus having the digital signal generating apparatus according to the present invention; and
FIG. 6 is a graph illustrating the dither signal frequency characteristic according to the embodiment.

### DESCRIPTION OF THE INVENTION

The following is a detailed description of a digital signal processing apparatus and a dither signal generating apparatus according to the present invention.

FIG. 4 is a block diagram showing a dither generator 10 according to an embodiment of the present invention. Here, a reference numeral 1 denotes an M-series data generator for generating random data, a reference numeral 2 denotes a delay circuit such as flip-flops, a reference numeral 3 denotes a polarity inverter and a reference numeral 4 denotes an adder.

Output data from the M-series data generator 1 are supplied to the delay circuit 2 and the polarity inverter 3. An output from the delay circuit 2 and an output from the polarity inverter 3 are added together at the adder 4, with an output from the adder 4 then being used as the dither signal.

Data generated at different times can be handled in the same way as data outputted from a plurality of M-series data generators because random data generated at the M-series data generator 1 have no self-correlation except for a constant cycle data. Also, a subtractor is composed of the polarity inverter 3 and the adder 4.

Accordingly, delayed data outputted at the delay circuit 2 and the data inputted at the polarity inverter 3 are completely non-correlating at a point in time. A subtraction process is then carried out between two kinds of non-correlating data by adding the outputted data which have been polarity inverted with the delayed data at the adder 4.

The noise data obtained by adding (subtracting) two kinds of non-correlating data are taken as the distribution dither signal. Namely, as shown by the solid line (2) in FIG. 1, and as mentioned above, if a zero noise level is randomly taken as the frequency peak, a level distribution characteristic in which the generated frequency reduces as the absolute value for the level becomes large is obtained.

The delay time for the delay circuit 2 is taken as a time which, for example, corresponds to the period of the sampling frequency Fₛ.

Usually, data which is not at the sampling frequency usually undergoes frequency filter processing via addition or subtraction. Namely, the delay time for the delay circuit 2 is made to have the period of the sampling frequency Fₛ. Data which is then only out by the period of the sampling frequency Fₛ is subjected to subtraction processing by the polarity inverter 3 and the adder 4 so that a primary high-pass filter is formed.

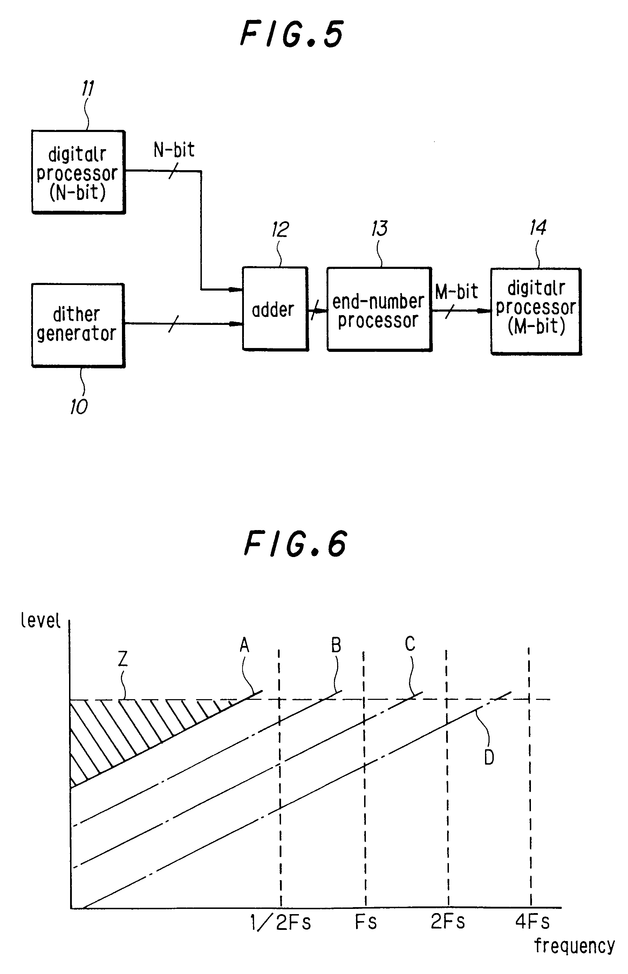

Dither signals generated by this dither generator 10 have the kind of frequency characteristic shown, for example, by the solid line A shown in FIG. 6.

It is also possible to arrange the polarity inverter 3 at the dither generator 10 so that the polarity of the delayed data side is inverted.

FIG. 5 is a block diagram showing an example of a digital signal processing apparatus having the dither generator 10 shown in FIG. 4 for carrying out re-quantization from N-bit data to M-bit data. In this case, the output of the digital processor which outputs the N-bit digital data is sent to a digital processor 14 which carries out M-bit (N>M) digital processing.

Namely, with respect to the N-bit data, the dither signal generated at the dither generator 10 is added at an adder 12. M-bit re-quantization processing is then carried out by rounding down or rounding off the lower bits of bit number N-M at a fraction processing circuit 13.

The linearity of the re-quantized data can be increased by adding the dither signal in this way and re-quantizing. In the embodiment, the noise generation due to the dither signal occurring in the audible band is then reduced because the dither signal has the kind of frequency characteristic shown by A in FIG. 6 where an amount of the high frequency component is larger than that of the low frequency component (audible frequency band component). The broken line Z in FIG. 6 shows the frequency characteristic for a usual dither signal. It can be seen that the noise energy is reduced corresponding to the hatched region within the audible band in accordance with the dither signal A when compared with this usual example. If Fₛ is taken to be, for example, about 40 KHz, the audible band will be less than 1/2Fₛ.

The problem of making the level of the dither signal larger no longer exists as a result of the noise within the audible bandwidth having been reduced. This also means that the effect of the increase in the linearity is increased.

Also, at the dither circuit 10, it is possible to generate dither signals having the kind of characteristics shown by the dot and dashed lines B, C and D shown, for example, in FIG. 6, by carrying out processing and setting the delay times at the delay circuit 2 while replacing the sampling frequency Fₛ with nFₛ (n=2, 4, 8 . . . ). In FIG. 6, the cases are shown where processing is carried out for B=2Fₛ, C=4Fₛ and D=8Fₛ.

In this way, the noise level within the audible frequency band can be reduced so that the linearity can be increased to great effect as a result of increases in the level of the dither signal.

In the embodiment, the linearity of the re-quantized data is raised while at the same time, the audible noise level is reduced. It also becomes possible to generate a distribution dither signal which has a frequency peak when the noise level is zero and for which the generating frequency reduces as the absolute value for the level becomes large while using just one M-series data generator.

Also, the present invention is by no means limited to the structure of this kind of embodiment and variable modifications are possible within the scope of the claims. For example, the random data generating apparatus does not have to be an M-series data generator. The delay circuit may also be composed a plurality of high order filters and a wide variety of settings may be considered for the frequency characteristic of the obtained frequency signal.

## Claims

1. A digital signal processing apparatus comprising:
signal generating means (10) for generating a dither signal having a larger amount of a high frequency component than that of a low frequency component;
addition means (12) for adding a dither signal from said signal generating means (10) and an inputted signal (11); and
re-quantization means (13) for carrying out re-quantization processing on an output signal from said addition means.

2. A digital signal processing apparatus according to claim 1, wherein said signal generating means (10) comprises data generating means (1) for generating non-correlating data and filtering means (2,3,4) for filtering the non-correlating data outputted from said data generating means and outputting the high frequency component of the non-correlating data.

3. A digital signal processing apparatus according to claims 1 or 2, wherein said signal generating means (10) comprises data generating means (1) for generating non-correlating data, delay means (2) for delaying the non-correlated data outputted from said data generating means and subtraction means (3,4) for subtracting the output from said delay means and the output from said data generating means.

4. A digital signal processing apparatus according to claim 3, wherein said subtracting means further comprises polarity inverting means (3) for inverting a polarity of an output from said data generating means and an addition means (4) for adding the output from said polarity inverting means and the output from said delay means.

5. A dither signal generator for generating a dither signal having a larger amount of a high frequency component than that of a low frequency component comprising:
data generating means (1) for generating non-correlating data; and
signal generating means (10) for generating a dither signal having a larger amount of a high frequency component than that of a low frequency component by subtracting (3,4) a delayed output for the non-correlating data outputted from said data generating means and the output from said data generating means (1).

6. A dither signal generating apparatus according to claim 5, wherein said signal generating means (10) comprises delay means (2) for delaying the output from said data generating means (1) and subtraction means (3,4) for subtracting the output from said data generating means and the output from said data generating means.

7. A dither signal generating means according to claim 6, wherein said subtraction means comprises polarity inverting means (3) for inverting the polarity of an output from the data generating means and addition means (4) for adding the output from said polarity inverting means and the output from said delay means (2).

8. A dither signal generating means according to claim 6, wherein the delay means (2) delays the non-correlating data outputted from said data generating means by a period of time corresponding to a period of a sampling frequency.

9. A digital signal processing method for carrying out a re-quantization process for turning an inputted digital signal into a digital signal with a smaller bit number, said process comprising the steps of:
subtracting (3,4) delayed non-correlating data outputted from a data generating means (1) and non-correlating data outputted from the data generating means (1) to thereby form a dither signal having a larger amount of a high frequency component than that of a low frequency component; and
adding (12) a generated dither signal and an inputted dither signal; and re-quantizing (13) the added signal.

10. A digital signal processing method according to claim 9, wherein said subtracting comprises adding (4) said delayed non-correlating data outputted from said data generating means (1) and an output, whose polarity has been inverted (3), from said data generating means (1).
